## Europäisches Patentamt

## European Patent Office

## Office européen des brevets

(19)

(11) Veröffentlichungsnummer: **0 178 655**
**B1**

(12) **EUROPÄISCHE PATENTSCHRIFT**

(45) Veröffentlichungstag der Patentschrift:
08.08.90

(51) Int. Cl.⁵: **H03H 9/64**

(21) Anmeldenummer: 85113143.3

(22) Anmeldetag: 16.10.85

(54) Akustisches Wellenfilter.

(30) Priorität: 18.10.84 DE 3438246

(43) Veröffentlichungstag der Anmeldung:
23.04.86 Patentblatt 86/17

(45) Bekanntmachung des Hinweises auf die Patenterteilung:
08.08.90 Patentblatt 90/32

(84) Benannte Vertragsstaaten:
AT BE CH DE FR GB IT LI NL SE

(56) Entgegenhaltungen:
EP-A- 0 016 979
US-A- 3 550 045

1976 IEEE MTT-S INTERNATIONAL MICROWAVE SYMPOSIUM DIGEST OF TECHNICAL PAPERS, Cherry Hill, 14.-16. Juni 1976, Seiten 283-285, IEEE, New York, US; G.L.MATTHAEI: "Acoustic-surface-wave resonators for band-pass filter applications

(73) Patentinhaber: Siemens Aktiengesellschaft,
Wittelsbacherplatz 2, D-8000 München 2(DE)

(72) Erfinder: Zibis, Peter, Dipl.-Ing.,
Gerhard-Hauptmann-Ring 40, D-8000 München 83(DE)
Erfinder: Veith, Richard, Dipl.-Phys., Habichtstrasse 25,
D-8025 Unterhaching(DE)

## Beschreibung

Die vorliegende Erfindung bezieht sich auf ein Filter, wie es im Oberbegriff des Patentanspruchs 1 angegeben ist.

Ein Wellenfilter mit drei Digitalstrukturen und gegenseitig unterschiedlichen Resonanzfrequenzen ist aus der US-A 3 550 043 bekannt. Die Eigenschaft dieses Filters ist, eine vergleichsweise zur Resonanzkurve seiner einzelnen Digitalstrukturen verbreiterte Resonanzkurve zu bieten. Dieses Filter besitzt symmetrisch zueinander frequenzverschobene, nebeneinander auf dem Substrat angeordnete Ausgangswandler, die zudem, bezogen auf den Filterausgang, elektrisch in Reihe geschaltet sind.

Aus der US-A 4 325 037 bzw. aus der europäischen Patentschrift EP-A 0 016 979 ist ein Filter mit in einem Substrat in bzw. nahe der Oberfläche laufenden akustischen Wellen bekannt. Bei diesem Filter ist zur Vermeidung des triple transit Signals vorgesehen, die Frequenz des schmalbandigeren von zwei in dem Filter vorhandenen Wandlern auf die eine oder die andere der beiden Reflektorfrequenzen $f_{R1}$, $f_{R2}$ zu legen. Dies findet insbesondere auch bei einer Reflektoranordnung Anwendung, die aus einem Eingangswandler und einem Ausgangswandler sowie Reflektorstrukturen besteht. Eine solche Anordnung ist in den obengenannten Patenschriften mit der Figur 4 wiedergegeben. Weitere Einzelheiten zu dem oben erörterten Stand der Technik gehen aus den obengenannten Patentschriften hervor, deren Inhalt als für den einschlägigen Fachmann bekannt hiermit ergänzender Inhalt der vorliegenden Erfindungsbeschreibung ist.

Zu den hier in Frage kommenden akustischen Wellen gehören die Oberflächenwellen im engeren Sinne (Ralegh-Wellen; Bleustein-Wellen), nahe der Oberfläche laufende Quer- und Scherwellen (wie Surface Skimming Bulk Waves) sowie auch oberflächennah laufende Anteile von (longitudinal polarisierten) Volumenwellen. Nachfolgend werden diese Wellenart als Oberflächenwellen (im allgemeineren Sinn verstanden) bezeichnet. Welche Wellenart im Einzelfall erzeugt wird, hängt von dem Fachmann bekannten Maßnahmen der Dimensionierung der Wandler und gegebenenfalls auch von Anisotropie-Eigenschaften des Substrats ab.

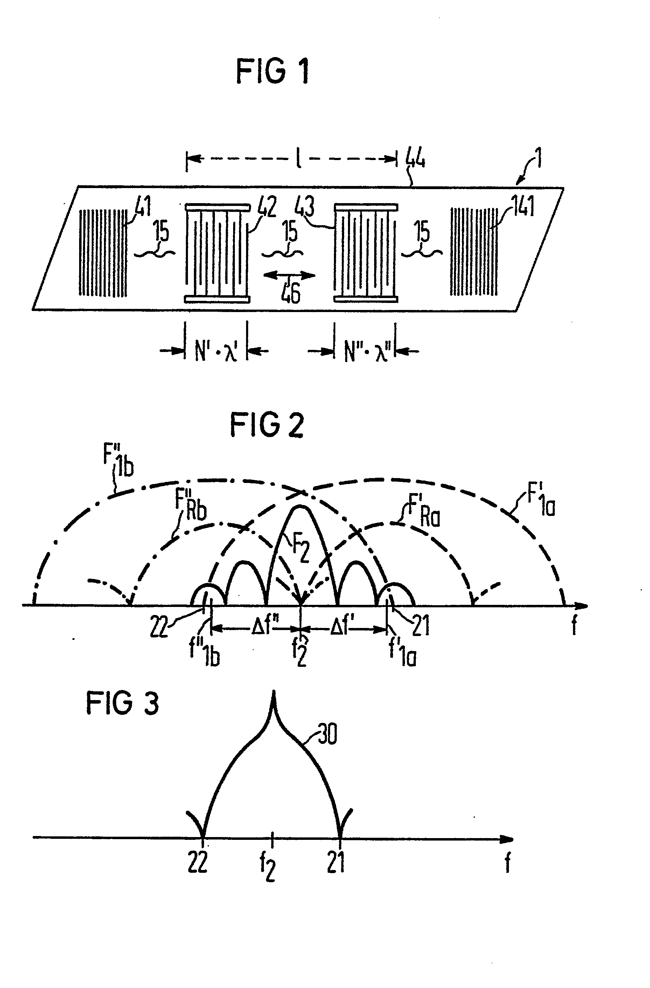

(Ohne die Bemessungen N″ • λ und N′ • λ′) zeigt die hier beigefügte Figur 1, die der Figur 4 der obengenannten Druckschriften entspricht, ein als Resonator ausgebildetes Wellenfilter 1 mit zwei Reflektorstrukturen 41 und 141, die insgesamt als eine Reflektorstruktur zu betrachten sind und die aus entsprechenden Reflektorstreifen bestehen. Die Streifen können Metallisierungsstreifen oder Gruben sein. Der Eingangswandler und der Ausgangswandler sind mit 42 und 43 bezeichnet, wobei die jeweilige Zuordnung wahlweise ist. Mit 46 ist die Hauptfortpflanzungsrichtung der in diesem Filter auftretenden Wellen angegeben, wobei mit 15 auf diese Wellen hingewiesen ist. Die Struktur dieses Wellenfilters 1 ist auf einem Substratkörper realisiert. Bei diesem bekannten Filter ist die Beseitigung der interdigitalen Reflexionen auf die Gesamtstruktur der Wandler 42 und 43 zusammengenommen bezogen. Für die Länge 1 der Interdigitalstrukturen 42 und 43 gilt dort 1 = N• λ, worin λ die akustische Wellenlänge und N die Anzahl der in die Länge 1 fallenden Wellenlängen der Oberflächenwelle 15 ist.

Wie dies in den obengenannten Druckschriften eingehend beschrieben ist, wird ein durch an sich unerwünschte interdigitale Reflexionen ansonsten erzeugtes Störsignal $F_R$ dadurch verhindert, daß die breitbandigere Digitalstruktur 42, 43 wenigstens zweifach breitbandiger als die schmalbandigere Digital-Reflektorstruktur 41, 141 bemessen ist und daß für die Mittenfrequenz f1 der breitbandigeren Digitialstruktur 42, 43 der eine der beiden sich aus der mathematischen Ableitung ergebenden für das bekannte Filter gleichwertigen Frequenzwerte $f_{1a}$ und $f_{1b}$

$$f_{1a,b} = \frac{f_2}{1 \pm \frac{1}{2N-1}}$$

gewählt ist. Darin ist $f_2$ die Mittenfrequenz der schmalbandigeren Struktur 41, 141.

Es ist eine Aufgabe der vorliegenden Erfindung, eine weitere Verbesserung zu einem wie oben angegebenen Filter mit Reflektorstruktur anzugeben, wobei diese Verbesserung zu der Beseitigung eines Einbruchs und damit verbundenen relativen Maximums in der Frequenzkurve des neuen Wellenfilters führt. Erfindungsgemäß wird diese Verbesserung mit den Maßnahmen des Patentanspruchs 1 gelöst.

Insbesondere für den Fall der Anwendung eines solchen Filters 1 nach Fig.1 als 'front end'-Filter mit entsprechend möglichst niedrigem Verlust bzw. möglichst niedriger Einfügungsdämpfung, hat sich gezeigt, daß ein bei dem entsprechenden bekannten Filter noch vorliegender Frequenzeinbruch mit zusätzlichem relativen Maximum in der Filterkurve in der Nähe der Mittenfrequenz $f_2$ beseitigt sein sollte. In diesem Zusammenhang wurde gefunden, daß bei einem entsprechenden, erfindungsgemäßen Filter mit einem Eingangswandler und mit einem Ausgangswandler 42, 43 dies dadurch zu erreichen ist, daß man die zu wählende Mittenfrequenz $f'_1$ des einen dieser beiden Wandler 42, 43 (z.B. des als Eingangswandler betriebenen Wandlers) auf die eine der beiden nach dem Prinzip des bekannten Filters sich ergebenden obengenannten Frequenzen und die Mittenfrequenz f″ des anderen dieser beiden Wandler (z.B. des Ausgangswandlers) auf die andere dieser beiden Frequenzen legt. Bevorzugt werden hierbei Wandler mit im wesentlichen gleicher Wellenlängenanzahl ihrer interdigitalen Fingerstrukturen vorgesehen. Bei der Erfindung werden aber für die Frequenzwerte f'$_a$ und f'$_b$ bzw. f"$_a$ und f"$_b$ die Größen N', N" zugrundegelegt.

$$f'_{1a,1b} = \frac{f_2}{1 \pm \frac{1}{N'-1}} \quad ; \quad f"_{1a,1b} = \frac{f_2}{1 \pm \frac{1}{N"-1}}$$

Diese ergeben sich bei der Erfindung jedoch (siehe Fig.1) aus N'.λ'= Länge nur des einen Wandlers (z.B.42) und N".λ"= Länge nur des anderen Wandlers (z.B. 43). Dem einen Wandler gibt man dann die Frequenz f'$_{1a}$, die sich aus dem einen Vorzeichen in der Gleichung ergibt, und dem anderen Wandler die Frequenz f"$_{1b}$ des anderen Vorzeichens.

Bei der Erfindung gibt man den beiden Wandlern eine gegenseitige Frequenzverstimmung von Δf'+Δf" = |f'$_{1a}$-f"$_{1b}$|, wobei die Mittenfrequenz f$_2$ des gesamten Filters 1 wenigstens nahezu gleich weit entfernt von den nunmehr voneinander verschiedenen Mittenfrequenzen f'$_{1a}$-f"$_{1b}$ des Eingangswandlers und des Ausgangswandlers liegt. Bei der vorliegenden Erfindung hat die wenigstens zweifach schmalbandigere Reflektorstruktur 41, 141 weiterhin die Resonanzfrequenz f$_2$, die im wesentlichen gleich der vorgegebenen (Mitten-) Frequenz des ganzen Wellenfilters (Fig.1) ist.

Mit der Erfindung ist bewirkt, daß sowohl für die einzelnen Wandler 42, 43 selbst als auch zwischen diesen Wandlern interdigitale Reflexionen im relevanten Frequenzbereich unschädlich gemacht sind.

Die der Erfindung zugrundeliegende Aufgabe läßt sich wie ersichtlich mit überraschend einfachen Mitteln technologisch realisieren, denn bei der Herstellung eines derartigen Filters nach einem einmal erstellten Filterentwurf ist es insbesondere bei der Herstellung nach dem 'Step'-Ver- (siehe hierzu DE-OS 3314602.0) unerheblich, ob für den Eingangswandler einerseits und für den Ausgangswandler andererseits jeweils gleiche Fingerabstände oder der Erfindung entsprechend unterschiedliche Fingerabstände einzuhalten sind. Die oben angesprochenen jeweiligen Frequenzen f'$_{1a}$, f'$_{1b}$ für den Eingangswandler und für den Ausgangswandler ergeben sich bekanntlich aus den Abständen der Finger im jeweils betreffenden Wandler 42, 43.

Fig.2 zeigt das Frequenzschema eines erfindungsgemäßen Filters nach Fig.1. Auf der Abszisse sind die Frequenzwerte aufgetragen. Mit F$_2$ ist die Resonanzkurve der schmalbandigeren Reflektorstruktur 41, 141 des Filters bezeichnet. Diese Resonanzkurve hat übliche Nebenmaxima. Gegenüber der Mittenfrequenz f$_2$ dieser Resonanzkurve F$_2$ sind die Resonanzfrequenzen der beiden einzelnen Interdigitalwandler 42 und 43 verschoben. Dem Wandler 42 ist in Fig.2 die Resonanzfrequenz f'$_{1a}$ zugeordnet. Die diesem Wandler 42 zugehörige Resonanzkurve ist mit F'$_{1a}$ bezeichnet. Erfindungsgemäß hat der Interdigitalwandler 43 die Mittenfrequenz f"$_{1b}$ mit der Resonanzkurve F$_{1b}$. Außerdem sind in Fig.2 die Frequenzkurven F'$_{Ra}$ und F"$_{Rb}$ der jeweiligen interdigitalen Reflexionen eingetragen. Aufgrund der vorliegenden Erfindung fällt das jeweils eine Minimum dieser Kurven F'$_{Ra}$, F"$_{Rb}$ mit der Mittenfrequenz f$_2$ des gesamten Filters 1 zusammen, so daß die Störungen minimalisiert sind.

Fig.3 zeigt die Filterkurve 30 des ganzen erfindungsgemäßen Filters 1. Die ersten Null-Stellen recht und links vom Hauptmaximum fallen mit den entsprechenden Null-Stellen 21, 22 der Resonanzkurven F'$_{1a}$ und F"$_{1b}$ zusammen. Bei gleicher Wellenlängen-Anzahl N'=N" beider Wandler fallen die Null-Stellen 21 bzw. 22 mit den Frequenzen f'$_{1a}$ und f"$_{1b}$ zusammen.

Es sei darauf hingewiesen, daß an sich die Länge der Wandler 42 und 43 auch bei gleich großer Wellenlängen-Anzahl der einzelnen Wandler nicht ganz genau gleich groß sind. Entsprechend den sich ergebenden Frequenzwerten f'$_{1a}$ verschieden von f"$_{1b}$ sind die Fingerabstände in dem einen Wandler um weniger verschieden groß gegenüber dem anderen Wandler. Die Abstände der Finger eines Wandlers ergeben die jeweilige Resonanzfrequenz f'$_{1a}$, f"$_{1b}$ mit den Wellenlängen λ' und λ".

Die Wellenlängen λ' und λ" sind, wie aus dem Obigen hervorgeht, etwas verschieden voneinander. Für die Wellenlängen- Anzahl N', N" kommen bevorzugt Werte zwischen 10 und 300 in Betracht. Die Länge eines jeweiligen Digitalwandlers 42, 43 ist ein Maß für dessen Bandbreite.

## Patentansprüche

1. Akustisches Wellenfilter,
 – mit einer Digitalstruktur (42) als Eingangswandler,
 – mit einer Digitalstruktur (43) als Ausgangswandler,
 – mit einer weiteren Digitalstruktur (41, 141) als Reflektorstruktur
 – wobei diese weitere Digitalstruktur die Mittenfrequenz f$_2$ hat und wenigstens zweifach schmalbandiger als die erstgenannten Digitalstrukturen (42, 43) ist, und wobei die Mittenfrequenz f$_1$ dieser erstgenannten Digitalstrukturen (42, 43) gegenüber der Mittenfrequenz f$_2$ verschoben ist und die Gleichung

$$f_1 = \frac{f_2}{1 \pm \frac{1}{N-1}}$$

gilt, worin N eine Wellenlängen-Anzahl ist, gekennzeichnet dadurch,
– daß die Resonanzfrequenz $f'_{1a}$ der einen (42) der beiden Digitalstrukturen (42, 43) verschieden bemessen ist von der Bemessung der Resonanzfrequenz $f''_{1b}$ der anderen (43) der beiden Digitalstrukturen,
– daß gilt

$$f'_{1a} = \frac{f_2}{1 - \frac{1}{N'-1}} \quad ,$$

– daß gilt

$$f''_{1b} = \frac{f_2}{1 + \frac{1}{N''-1}} \quad ,$$

– worin N' die für die eine (42) dieser Digitalstrukturen und N'' die für die andere (43) dieser Digitalstrukturen jeweils geltende Anzahl der in die jeweilige Digitalstruktur (42, 43) passenden Wellenlängen λ ist, wobei N' und N'' wenigstens im wesentlichen gleich groß gewählte Zahlenwerte sind.

2. Akustische Wellenfilter nach Anspruch 1, **gekennzeichnet** dadurch, daß die Bandbreite $F_2$ der breitbandigeren Digitalstruktur (41, 141) um wenigstens den Faktor 5 schmalbandiger als die Bandbreite der jeweiligen Digitalstrukturen der beiden erstgenannten Digitalstrukturen (42, 43) ist.

3. Akustischer Wellenfilter nach Anspruch 1 oder 2, **gekennzeichnet** dadurch , daß die schmalbandigere Digitalstruktur (41, 141) eine Reflektorstruktur ist.

4. Akustisches Wellenfilter nach Anspruch 1, 2 oder 3, **gekennzeichnet** dadurch , daß die eine (42) der beiden Digitalstrukturen als Eingangswandler und die andere (43) der beiden erstgenannten Digitalstrukturen als Ausgangswandler vorgesehen sind.

## Claims

1. Acoustic wave filter,
– having a digital structure (42) as input transducer,
– having a digital structure (43) as output transducer,
– having a further digital structure (41, 141) as reflector structure,
– wherein this further digital structure has the centre frequency $f_2$ and a bandwidth which is at least twice as narrow as that of the first-mentioned digital structures (42, 43), and
– wherein the centre frequency $f_1$ of said first-mentioned digital structures (42, 43) is shifted relative to the centre frequency $f_2$, and the equation

$$f_1 = \frac{f_2}{1 \pm \frac{1}{N-1}}$$

is valid, wherein N is a wavelength number, characterized in that
– the resonant frequency $f'_{1a}$ of one (42) of the two digital structures (42, 43) is dimensioned differently from the dimensioning of the resonant frequency $f''_{1b}$ of the other (43) of the two digital structures,
– and

$$f'_{1a} = \frac{f_2}{1 - \frac{1}{N'-1}}$$

4

– and

$$f''_{1b} = \frac{f_2}{1 + \frac{1}{N''-1}}$$

– wherein N′ and N″ are in each case the applicable number of wavelengths λ fitting into the respective digital structure (42, 43) for the one (42) of these digital structures and for the other (43) of these digital structures, respectively, wherein N′ and N″ are numerical values selected to be at least essentially the same.

2. Acoustic wave filter according to Claim 1, characterized in that the bandwidth F₂ of the more broadbanded digital structure (41, 141) is narrower in bandwidth by at least a factor of 5 than the bandwidth of the respective digital structures of the two first-mentioned digital structures (42, 43).

3. Acoustic wave filter according to Claim 1 or 2, characterized in that the more narrow-banded digital structure (41, 141) is a reflector structure.

4. Acoustic wave filter according to Claim 1, 2 or 3, characterized in that the one (42) of the two digital structures is provided as input transducer and the other (43) of the two first-mentioned digital structures is provided as output transducer.

## Revendications

1. Filtre d'ondes acoustiques,
– comportant une structure digitée (42) en tant que transducteur d'entrée,
– comportant une structure digitée (43) en tant que transducteur de sortie,
– comportant une autre structure digitée (41, 141) en tant que strucutre formant réflecteur,
– et dans lequel cette autre structure digitée possède la fréquence centrale (f₂) et une largeur de bande au moins deux fois plus faible que les structure digitées (42, 43) indiquées en premier lieu, et
– dans lequel la fréquence centrale (f₁) de ces structure digitées (42, 43) indiquées en premier lieu est décalée par rapport à la fréquence centrale (f₂) avec la relation

$$f_1 = \frac{f_2}{1 \pm \frac{1}{N-1}}$$

N étant un nombre de longueurs d'ondes, caractérisé par le fait
– que la fréquence de résonance (f′₁ₐ) de l'une (42) des deux structure digitées (42, 43) est choisie différente de la fréquence de résonance (f″₁b) de l'autre (43) des deux structure digitées,
– que l'on a

$$f'_{1a} = \frac{f_2}{1 - \frac{1}{N'-1}} \quad ,$$

que l'on a

$$f''_{1b} = \frac{f_2}{1 + \frac{1}{N''-1}}$$

– N′ et N″ étant les nombres, qui sont respectivement valables pour l'une (42) et l'autre (43) de ces structure digitées, des longueurs d'onde λ adaptées aux structure digitées respectives (42, 43), et N′ et N″ possédant des valeurs numériques choisies de manière à être au moins sensiblement égales.

2. Filtre d'ondes acoustiques suivant la revendication 1, caractérisé par le fait que la largeur de bande (F₂) de la structure digitée (41, 141) possédant la largeur de bande la plus grande possède une largeur de bande inférieure, au moins du facteur 5, à la largeur de bande des structures digitées respectives des deux structures digitées (42, 43) indiquées en premier lieu.

3. Filtre d'ondes à acoustiques suivant la revendication 1 ou 2, caractérisé par le fait que la structure digitée (41, 141), qui possède une largeur de bande plus étroite, est une structure réfléchissante.

4. Filtre d'ondes acoustiques suivant la revendication 1, 2 ou 3, caractérisé par le fait que l'une (42) des deux structures digitées est prévue en tant que transducteur d'entrée et l'autre (43) des deux structures digitées indiquée en premier lieu est prévue comme transducteur de sortie.

# FIG 1

# FIG 2

# FIG 3